(19) Europäisches Patentamt / European Patent Office / Office européen des brevets

(11) **EP 3 021 361 A1**

(12) **DEMANDE DE BREVET EUROPEEN**

(43) Date de publication:
**18.05.2016 Bulletin 2016/20**

(51) Int Cl.:
*H01L 27/15* *(2006.01)*     *H01L 33/08* *(2010.01)*

(21) Numéro de dépôt: **15194793.4**

(22) Date de dépôt: **16.11.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **17.11.2014 FR 1461056**

(71) Demandeurs:
• **COMMISSARIAT A L'ENERGIE ATOMIQUE ET AUX ENERGIES ALTERNATIVES**
**75015 Paris (FR)**

• **ALCATEL LUCENT**
**92100 Boulogne-Billancourt (FR)**

(72) Inventeur: **Vaufrey, David**
**38000 GRENOBLE (FR)**

(74) Mandataire: **Novaimo**
**Bâtiment Europa 2**
**310 avenue Marie Curie**
**Archamps Technopole**
**74166 Saint-Julien-en-Genevois Cedex (FR)**

(54) **DISPOSITIF ÉMISSIF COMPORTANT DES PREMIER ET DEUXIÈME PIXELS ADJACENTS PARTAGEANT UN MÊME EMPILEMENT ÉMISSIF DE SEMI-CONDUCTEURS**

(57)    Le dispositif émissif comporte des premier et deuxième pixels (1a, 1b) adjacents partageant un empilement émissif (2) commun de semiconducteurs et définissant chacun une surface d'émission (4a, 4b) de photons. Les premier et deuxième pixels (1a, 1b) sont configurés de telle sorte qu'une alimentation en courant du premier pixel (1a) provoque l'émission de photons, par l'empilement émissif (2), uniquement au niveau de la surface d'émission (4a) dudit premier pixel (1a).

Figure 2

**Description**

**Domaine technique de l'invention**

L'invention concerne le domaine de l'électronique, et plus particulièrement de l'émission de photons.

L'invention a pour objet plus particulièrement un dispositif émissif comportant des premier et deuxième pixels adjacents.

**État de la technique**

Il existe de nombreux dispositifs/afficheurs capables d'afficher des données, ou tout simplement de réaliser un éclairage, ces derniers sont formés d'une multitude de sources de lumières juxtaposées pour former une matrice planaire. De tels afficheurs existent sous différentes formes : Plasma, LCD (écran à cristaux liquides), OLED (Diode Organique Electroluminescente), LED (Diode Electroluminescente) selon la nature de la source de lumière utilisée.

On distingue les afficheurs en deux grandes classes, les afficheurs émissifs et les afficheurs non émissifs. Un afficheur émissif se caractérise par l'existence de plusieurs sources lumineuses ponctuelles pilotées spécifiquement. Chaque source formant un pixel de l'afficheur. Au contraire, un afficheur non émissif est muni d'un retro éclairage constamment allumé et commun à tous les pixels, c'est le cas des écrans LCD. Dans les écrans LCD, le pixel est formé par une valve optique à base de cristaux liquides.

Les afficheurs se distinguent également par le mode d'adressage de leurs pixels. Il existe les matrices dites passives et les matrices dites actives. Dans une matrice passive, les pixels d'une même ligne (ou d'une même colonne) sont alimentés l'un après l'autre. En conséquence, le pixel n'est allumé que pendant un temps très court, et il faut donc l'alimenter avec une forte densité de courant pour que la luminance moyenne perçue par l'oeil sur un temps de balayage d'une ligne (ou d'une colonne) soit suffisante. Dans une matrice active, chaque pixel est alimenté individuellement et peut donc rester allumé jusqu'au prochain rafraichissement de l'image.

Il résulte de ce qui été dit ci-dessus qu'il est préférable que chaque pixel soit adressable de manière sélective, comme dans une matrice active, afin de pouvoir piloter les caractéristiques d'affichage dudit pixel.

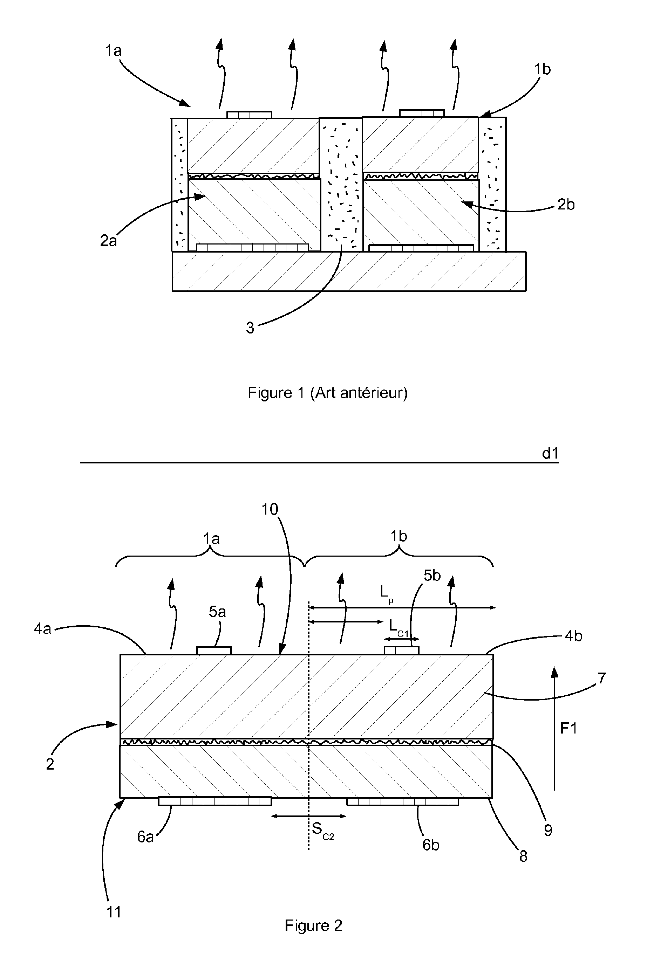

La figure 1 illustre deux pixels adjacents 1a, 1 b d'une matrice de pixels tel que connue de l'art antérieur, chaque pixel 1a, 1b comporte un empilement indépendant 2a, 2b qui lui est associé de telle sorte à permettre son affichage indépendant par adressage sélectif. Les pixels 1a, 1 b peuvent être obtenus par formation d'un empilement principal de couches qui est ensuite individualisé en empilements indépendants 2a, 2b pour pixels par formation d'îlots distincts au sein de l'empilement principal. Après individualisation, il est nécessaire de passiver les flancs latéraux de chaque empilement indépendant 2a, 2b pour éviter de court-circuiter la diode formant le pixel. La passivation est réalisée via dépôt d'un matériau adéquat 3.

Il en résulte que le nombre d'opérations technologiques au cours de la réalisation de tels afficheurs est élevé, et qu'il est difficile de miniaturiser les pixels du fait des espacements entre deux pixels et de la passivation nécessaire entre deux pixels.

**Objet de l'invention**

Le but de la présente invention est de proposer une solution qui remédie à tout ou partie des inconvénients listés ci-dessus, permettant notamment de miniaturiser les dispositifs connus.

On tend vers ce but grâce à un dispositif émissif comportant des premier et deuxième pixels adjacents partageant un empilement émissif commun de semi-conducteurs et définissant chacun une surface d'émission de photons, les premier et deuxième pixels étant configurés de telle sorte qu'une alimentation en courant du premier pixel provoque l'émission de photons, par l'empilement émissif, uniquement au niveau de la surface d'émission dudit premier pixel.

Notamment, dans le cadre de ce dispositif on peut avoir les caractéristiques suivantes :

- les premier et deuxième pixels comportent chacun un premier contact électrique configuré de sorte à injecter des porteurs de charge d'un premier type dans l'empilement émissif, et un deuxième contact électrique configuré de sorte à injecter des porteurs de charge d'un deuxième type dans l'empilement émissif,

- les premiers contacts électriques des premier et deuxième pixels sont reliés électriquement entre eux,

- les deuxièmes contacts électriques des premier et deuxième pixels sont configurés de sorte à être polarisés de manière sélective par un système d'adressage du dispositif émissif en vue de l'injection des porteurs de charge du deuxième type,

et lorsque le premier pixel est alimenté en courant, la densité de courant entre le premier contact électrique du deuxième pixel et le deuxième contact électrique du premier pixel est inférieure à la densité de courant pour lequel ledit deuxième pixel commence à émettre des photons.

Selon une mise en oeuvre, la surface de contact du premier contact électrique de chaque pixel avec l'empilement émissif est inférieure à la surface de contact du deuxième contact électrique de chaque pixel avec l'empilement émissif.

En particulier, le premier pixel peut comporter une longueur de dispersion du courant, et la distance de séparation du premier contact électrique du premier pixel avec le deuxième pixel est supérieure à une ou cinq fois la longueur de dispersion du courant du premier pixel.

Selon un exemple de réalisation particulier, les premier et deuxième pixels sont alignés le long d'une droite de telle sorte que $L_p$ est une dimension de chacun desdits premier et deuxième pixels selon ladite droite, ladite dimension desdits premier et deuxième pixels étant incluse dans une surface principale d'émission du dispositif émissif incluant les surfaces d'émission desdits premier et deuxième pixels, $L_{C1}$ est une dimension du premier contact de chacun des premier et deuxième pixels selon ladite droite et $S_{C2}$ est une distance séparant les deux deuxièmes contacts des premier et deuxième pixels selon ladite droite, et la distance D avec $D = \frac{L_P}{2} - \frac{L_{C1}}{2} + \frac{S_{C2}}{2}$ vérifie la condition D > Ls, ou D $\geq$ 5Ls, ou D $\geq$ 7Ls, ou D $\geq$ 11 Ls, où Ls est la longueur de dispersion du premier pixel.

En particulier, les premier et deuxième pixels peuvent comporter chacun un premier contact électrique configuré de sorte à injecter des porteurs de charge d'un premier type dans l'empilement émissif et un deuxième contact électrique configuré de sorte à injecter des porteurs de charge d'un deuxième type dans l'empilement émissif, et les premier et deuxième contacts électriques de chacun des premiers et deuxième pixels sont disposés de part et d'autre de l'empilement émissif sans être en vis-à-vis.

En particulier, les premiers contacts électriques des premier et deuxième pixels peuvent adopter une forme délimitant la périphérie des surfaces d'émission des premier et deuxième pixels, les premiers contacts électriques et deuxièmes contacts électriques des premier et deuxième pixels étant agencés de telle sorte que leurs projections sur un même plan, ledit même plan étant perpendiculaire à la direction d'empilement dudit l'empilement émissif, ne se recouvrent pas.

Notamment, les premiers contacts électriques des premier et deuxième pixels sont reliés électriquement entre eux.

Selon une mise en oeuvre, le dispositif peut comporter une configuration dans laquelle :

- les premiers contacts électriques des premier et deuxième pixels injectent des porteurs de charge du premier type dans l'empilement émissif,

- le deuxième contact électrique du premier pixel injecte des porteurs de charge du deuxième type dans l'empilement émissif,

- le centre du premier pixel perçoit la somme des contributions de chaque point du premier contact électrique du premier pixel de sorte qu'une partie de l'empilement émissif correspondant au premier pixel génère des photons,

- le deuxième contact électrique du deuxième pixel n'étant pas polarisé, les porteurs injectés par le deuxième contact électrique du premier pixel ne permettent pas de générer des photons au sein d'une autre partie de l'empilement émissif associée au deuxième pixel.

Selon une mise en oeuvre, l'empilement émissif comporte une première face, sur laquelle repose les premiers contacts électriques desdits premier et deuxième pixels, et une deuxième face, opposée à la première face, sur laquelle repose les deuxièmes contacts électriques desdits premier et deuxième pixels, ladite première face de l'empilement émissif formant une face principale d'émission du dispositif émissif.

Avantageusement, les premier et deuxième pixels sont identiques.

L'invention est aussi relative à un procédé d'élaboration d'un dispositif émissif comprenant des premier et deuxième pixels adjacents partageant un empilement émissif commun de semi-conducteurs et définissant chacun une surface d'émission de photons, ledit procédé comportant une étape de configuration de l'empilement émissif de telle sorte que l'alimentation en courant du premier pixel provoque l'émission de photons, par l'empilement émissif, uniquement au niveau de la surface d'émission dudit premier pixel.

Selon une mise en oeuvre, l'étape de configuration comporte :

- une étape dans laquelle la surface d'émission des premier et deuxième pixels est choisie,

- une étape dans laquelle des formes et dimensions des contacts électriques des premier et deuxième pixels sont choisies,

- une étape d'élaboration de l'empilement émissif en fonction des surfaces d'émission choisies et des formes et dimensions des contacts électriques choisis.

Notamment, l'étape d'élaboration de l'empilement émissif peut comporter une étape de détermination d'un empilement émissif de test et une étape de calcul de la longueur de dispersion associée à l'empilement de test déterminé, ledit empilement émissif de test étant validé si il satisfait un critère de comparaison de la longueur de dispersion calculée avec une dimension associée au moins au premier pixel.

**Description sommaire des dessins**

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 est une vue en coupe de deux pixels adjacents selon l'art antérieur,
- la figure 2 est une vue en coupe d'un dispositif émissif à deux pixels adjacents selon un mode de réalisation de l'invention,
- la figure 3 est une vue en coupe d'un dispositif émissif à deux pixels adjacents selon un autre mode de réalisation de l'invention,
- la figure 4 est une vue en perspective du dispositif de la figure 3.

**Description de modes préférentiels de l'invention**

Par « sensiblement », on entend dans la présente description exactement ou à plus ou moins 10%.

La présente invention se propose d'utiliser, pour une pluralité de pixels, un même empilement émissif commun. En ce sens, il n'y a plus besoin ni de réaliser des tranchées pour individualiser les empilements des pixels, ni de passiver l'espace entre deux pixels adjacents. Il en résulte que deux pixels adjacents peuvent être plus proches et/ou que la surface d'émission des pixels peut être augmentée. Ainsi, il devient plus simple de miniaturiser les dispositifs émissifs et/ou d'augmenter la résolution en termes de pixels pour une surface d'affichage constante du dispositif émissif.

La présente invention concerne plus particulièrement les dispositifs émissifs à base de diodes électroluminescentes (LED) disposant d'un adressage passif ou actif. L'invention est particulièrement adaptée pour les dispositifs émissifs à base de LED dont les pixels sont de très faibles dimensions.

Autrement dit, un pixel dans la présente description peut former une diode électroluminescente.

Jusqu'à présent, l'opinion générale était qu'il fallait que chaque pixel comporte son propre empilement indépendant de telle sorte que des porteurs injectés pour l'allumage de ce pixel ne puissent générer des photons qu'au niveau de ce pixel, c'est-à-dire afin d'éviter que l'adressage d'un pixel en particulier ne puisse provoquer la génération de photons au sein d'un pixel adjacent. La présente invention prévoit au contraire qu'une individualisation n'est pas nécessaire et qu'il est possible de configurer un premier pixel de telle sorte que son alimentation en courant provoque l'émission de photons uniquement au niveau d'une zone d'émission correspondant à la surface d'affichage dudit premier pixel, et ce même si ledit premier pixel partage un empilement commun avec un deuxième pixel qui lui est adjacent. Autrement dit, dans ce cas, la polarisation du premier pixel ne peut pas provoquer l'allumage du deuxième pixel si ce dernier est éteint.

Dans la présente description, par « pixels adjacents », on entend deux pixels dont les surfaces d'émission sont juxtaposées.

De manière général, chaque pixel est capable d'adopter sélectivement un état éteint et un état allumé. Dans l'état éteint, le pixel n'est pas émissif de photons et dans l'état allumé le pixel émet des photons.

Un pixel définit une surface d'émission. Selon la destination d'utilisation du dispositif émissif, cette surface d'émission est une surface d'affichage (cas d'un écran) ou une surface d'éclairage (cas d'une ampoule). La somme des différentes surfaces d'émission forme une surface principale d'émission du dispositif émissif. En particulier, la surface d'émission d'un pixel correspond à une face du pixel permettant la restitution des photons vers l'extérieur du dispositif lorsque le pixel correspondant est allumé. La surface d'émission d'un pixel peut comporter une partie recouverte, ou peut être délimitée, par une portion d'électrode destinée à injecter des porteurs dans l'empilement au niveau dudit pixel.

Selon une réalisation illustrée aux figures 2 à 4, le dispositif émissif comporte un premier pixel 1a et un deuxième pixel 1b adjacent au premier pixel 1a. Les premier et deuxième pixels 1a, 1b partagent un empilement émissif 2 commun de semi-conducteurs et définissent chacun une surface d'émission 4a, 4b de photons. Les premier et deuxième pixels

1a, 1 b sont configurés de telle sorte qu'une alimentation en courant du premier pixel 1a provoque l'émission de photons, par l'empilement émissif 2, uniquement au niveau de la surface d'émission 4a dudit premier pixel 1a. Préférentiellement, ladite configuration des premier et deuxième pixels 1a, 1b peut être aussi telle qu'une alimentation en courant du deuxième pixel 1b provoque l'émission de photons, par l'empilement émissif 2, uniquement au niveau de la surface d'émission 4b dudit deuxième pixel 1 b.

L'alimentation en courant d'un pixel donné peut être réalisée par des moyens adaptés.

Par exemple, l'alimentation en courant d'un pixel est réalisée par deux contacts électriques 5a, 6a (5b, 6b) formant électrodes, dudit pixel 1a, 1 b injectant des porteurs de charge dans une partie correspondante de l'empilement émissif 2. Les contacts électriques 5a, 6a (5b, 6b) sont disposés de part et d'autre de la partie correspondante de l'empilement émissif 2 et opposés selon la direction d'empilement dudit empilement F1. Ces deux contacts électriques 5a, 6a, (5b, 6b) sont respectivement une cathode et une anode. Selon une réalisation, les cathodes des pixels peuvent être toutes en contact électrique entre elles, et un système d'adressage permet d'adresser distinctement les anodes des pixels pour piloter l'allumage individuel d'un pixel. Inversement, il est aussi possible que les anodes puissent être toutes en contact électrique entre elles, et qu'un système d'adressage permette d'adresser distinctement les cathodes pour piloter l'allumage individuel d'un pixel.

Autrement dit, chaque pixel (premier et deuxième pixels dans l'exemple, mais non limité à seulement deux pixels) peut comporter un premier contact électrique d'un premier type, et un deuxième contact électrique d'un deuxième type (les premiers contacts électriques de tous les pixels étant disposés sur une première face de l'empilement émissif 2 et les deuxièmes contacts électriques de tous les pixels étant disposés sur une deuxième face, opposée à la première face, de l'empilement émissif 2) de telle sorte que lorsqu'un courant suffisant transite entre les premier et deuxième contacts d'un même pixel, ce dernier s'allume. Ici, les premiers contacts électriques de tous les pixels sont reliés électriquement entre eux et les deuxièmes contacts électriques de tous les pixels sont adressables individuellement. Le premier type et le deuxième type sont choisis parmi : une anode ou une cathode. Les surfaces d'émission des pixels peuvent être incluses au niveau de la première face ou de la deuxième face de l'empilement émissif 2. Dans le cas où l'empilement est destiné à former une diode GaN, il sera préféré que la cathode soit commune à tous les pixels.

L'empilement émissif 2 peut comporter différentes couches agencées selon une direction d'empilement illustrée par la flèche F1 aux figures 2 à 4. Les différentes couches de l'empilement émissif 2 sont alors préférentiellement incluses chacune dans un plan correspondant et sensiblement perpendiculaire à la direction F1 d'empilement émissif 2. Selon un exemple particulier, l'empilement émissif 2 comporte au moins une première couche semi-conductrice 7, notamment dopée n, une deuxième couche semi-conductrice 8, notamment dopée p. Préférentiellement, une couche active 9 est intercalée entre les première et deuxième couches 7, 8. La couche active 9 comporte, par exemple, des puits quantiques favorisant la recombinaison des porteurs injectés par les électrodes des différents pixels. Alternativement, la couche active 9 peut être formée par la simple interface de contact entre les couches 7 et 8.

Les première et deuxième couches semi-conductrices peuvent être formées en nitrure de gallium.

Préférentiellement, par « une alimentation en courant d'un pixel en particulier (le premier ou le deuxième dans l'exemple) provoque l'émission de photons, par l'empilement émissif, uniquement au niveau de la surface d'émission dudit pixel en particulier », on comprend que le dispositif émissif est tel que lorsqu'un pixel adjacent audit pixel particulier est dans son état éteint, l'état allumé du pixel particulier n'a pas d'influence sur l'état du pixel adjacent.

La configuration souhaitée d'un pixel pour éviter que ce dernier ne provoque un allumage ou une modification de l'allumage d'un pixel adjacent est notamment dictée par une maîtrise de la distribution du courant injecté dans la partie de l'empilement émissif correspondant à un pixel, notamment dans la couche active de l'empilement émissif commun. En ce sens, deux pixels adjacents peuvent être dimensionnés en tenant compte de la longueur de dispersion du courant aussi connue dans le domaine sous la dénomination « longueur de spreading » (de l'anglais « spreading length »). Cette longueur de dispersion du courant permet de décrire la distribution du courant le cas échéant dans le plan de la couche active de l'empilement émissif. De manière plus détaillée, la longueur de dispersion du courant traduit la distance dans le plan de la couche active en deux points, le premier point étant traversé par une densité de courant maximale et le second point par une densité de courant égale à la densité de courant maximale divisée par e (nombre d'Euler) : $J(x)/J(x=0)=1/e$.

La longueur de dispersion du courant peut être calculée dès lors que les épaisseurs et résistivités des couches de l'empilement émissif sont connues en utilisant la formule suivante :

$$Ls = \sqrt{\left( \sum \rho_c + \sum \rho_\perp . d_\perp \right) . \left| \frac{\rho_n}{d_n} - \frac{\rho_e}{d_e} \right|^{-1}}$$

$\sum \rho_c$ correspond à la somme des résistances de contact entre les différents matériaux du dispositif. La formule peut se simplifier en négligeant ce terme.

$\sum\rho_{\perp}.d_{\perp}$ correspond à la somme des produits de la résistance et de l'épaisseur des différents matériaux traversés par un axe normal au plan du dispositif.

$\rho_n$, $\rho_e$ correspond aux résistivités des couches respectivement dopée n et de l'électrode en contact de la couche dopée p.

$d_n$,$d_e$ correspond aux épaisseurs de la couche dopée n et de l'électrode en contact de la couche dopée p. Cette épaisseur est donnée selon un axe parallèle à la direction d'empilement dudit empilement émissif.

Dès lors, on comprend qu'en prenant en compte la longueur de dispersion du courant au cours de l'élaboration du dispositif émissif, il est possible de concevoir ce dernier pour en maximiser le rendement d'émission lumineuse.

En ce sens, l'invention est aussi relative à un procédé d'élaboration du dispositif émissif tel que décrit. Ce procédé comportant notamment une étape de configuration de l'empilement émissif 2 de telle sorte que l'alimentation en courant du premier pixel 1a provoque l'émission de photons, par l'empilement émissif 2, uniquement au niveau de la surface d'émission 4a dudit premier pixel 1 b.

Cette étape de configuration peut comporter notamment une étape de calcul de la longueur de dispersion d'un empilement du dispositif émissif en vue de valider ou non le bon fonctionnement du dispositif émissif. En particulier, le calcul de la longueur de dispersion peut être réalisé en déterminant (de manière théorique ou par mesure) les résistivités et les épaisseurs des couches de l'empilement émissif 2. Le choix, c'est-à-dire la validation d'un empilement, pourra être fait lorsque l'empilement émissif 2 permet d'obtenir une longueur de dispersion choisie. De préférence, les épaisseurs des couches de l'empilement émissif 2 seront modulées de sorte à conserver des résistivités minimales en vue d'apporter un gain de temps à la fabrication et une diminution des coûts de production puisque les épitaxies seront moins longues. Une fois validé, le dispositif émissif peut être industrialisé. La longueur de dispersion choisie peut être fonction des dimensions des pixels du dispositif émissif et notamment des formes et dimensions des contacts électriques (premier et deuxième contacts électriques) de chacun des pixels.

En relation avec ce qui a été écrit ci-avant, les premier et deuxième pixels 1a, 1b comportent chacun un premier contact électrique 5a, 5b configuré de sorte à injecter des porteurs de charge d'un premier type dans l'empilement émissif 2 et un deuxième contact électrique 6a, 6b configuré de sorte à injecter des porteurs de charge d'un deuxième type dans l'empilement émissif 2.

Les porteurs de charge peuvent être de type électron ou trou.

L'empilement émissif 2 peut comporter une première face 10, sur laquelle repose les premiers contacts électriques 5a, 5b desdits premier et deuxième pixels 1 a, 1 b, et une deuxième face 11, opposée à la première face 10, sur laquelle repose les deuxièmes contacts 6a, 6b desdits premier et deuxième pixels 1a, 1b. Les première et deuxième faces 10, 11 sont disposées le long d'une droite parallèle la direction F1 d'empilement dudit empilement émissif 2, et préférentiellement incluses chacune dans un plan correspondant perpendiculaire à la direction F1 d'empilement dudit empilement émissif 2. Préférentiellement, la première face 10 de l'empilement émissif 2 forme la face principale d'émission du dispositif émissif.

Selon un premier mode d'exécution particulier illustré en figure 2, les premiers contacts électriques 5a, 5b des premier et deuxième pixels 1a, 1 b sont reliés électriquement entre eux. Autrement dit, ils peuvent former une unique électrode divisée en plusieurs zones, chaque zone formant alors le premier contact électrique 5a, 5b d'un pixel correspondant 1a, 1 b. Dans ce cas, les deuxièmes contacts électriques 6a, 6b des premier et deuxième pixels 1a, 1 b peuvent être configurés de sorte à être polarisés de manière sélective par un système d'adressage du dispositif émissif en vue de l'injection des porteurs de charge du deuxième type dans l'empilement émissif 2. Ainsi, pour éviter un allumage intempestif du deuxième pixel 1 b, lorsque le premier pixel 1a est alimenté en courant la densité de courant entre le premier contact électrique 5b du deuxième pixel 1b et le deuxième contact électrique 6a du premier pixel 1a est inférieure à la densité de courant pour lequel ledit deuxième pixel 1b commence à émettre des photons.

On comprend alors ici que le dispositif émissif est tel qu'il peut comporter une configuration dans laquelle :

- les porteurs de charge du premier type sont injectés dans l'empilement émissif 2 au niveau des premier et deuxième pixels 1a, 1 b,

- seul le deuxième contact électrique 6a du premier pixel 1 a est polarisé de sorte à injecter les porteurs de charge du deuxième type dans l'empilement émissif 2 au niveau du premier pixel 1 a,

- le courant est nul entre le deuxième contact 6a du premier pixel 1 a et le premier contact 5b du deuxième pixel 1 b, de telle sorte que les porteurs de charge du premier type injectés au niveau du deuxième pixel 1 b ne puissent pas se recombiner au sein dudit deuxième pixel 1 b avec des porteurs de charge du deuxième type injectés par le deuxième contact 6a du premier pixel 1 a.

Dans le premier mode de réalisation, la surface de contact du premier contact électrique 5a, 5b de chaque pixel 1a, 1 b avec l'empilement émissif 2 est préférentiellement inférieure à la surface de contact du deuxième contact électrique 6a, 6b de chaque pixel 1a, 1 b avec l'empilement émissif 2. Pour des raisons d'efficacité d'émission de photons par l'empilement émissif, les premiers contacts électriques des différents pixels seront disposés au niveau de la surface d'émission du pixel correspondant de sorte à limiter l'ombrage de la couche active de l'empilement émissif et donc limiter l'absorption des photons générés au sein de l'empilement émissif 2 par les premiers contacts électriques. Autrement dit, le premier contact électrique 5a, 5b de chaque pixel 1 a, 1 b ombre une partie de la surface d'émission 4a, 4b dudit pixel 1a, 1 b. Le premier contact électrique 5a, 5b de chaque pixel 1a, 1 b peut être formé à la verticale du deuxième contact électrique 6a, 6b correspondant dans un référentiel où un plan horizontal inclut ledit deuxième contact électrique 6a, 6b. On comprend alors que ladite première face 10 de l'empilement émissif 2 forme la face principale d'émission du dispositif émissif. En outre, ici les premiers contacts électriques sont préférentiellement formés au centre de la surface d'émission associée du pixel correspondant. Bien entendu, l'inverse est aussi vrai lorsque les surfaces d'émission des pixels sont associées aux deuxièmes contacts 6a, 6b, dans ce cas, la surface de contact du premier contact 5a, 5b de chaque pixel avec l'empilement émissif 2 est préférentiellement supérieure à la surface de contact de chaque deuxième contact 6a, 6b avec l'empilement émissif 2.

Pour en revenir à la longueur de dispersion du courant, selon ce premier mode de réalisation, le premier pixel 1a comporte une longueur de dispersion du courant, et la distance de séparation du premier contact électrique 5a du premier pixel 1a avec le deuxième pixel 1 b est supérieure ou égale à cinq fois la longueur de dispersion du courant du premier pixel 1a. L'inverse est préférentiellement aussi vrai en inversant les premier et deuxième pixels.

Selon une mise en oeuvre particulière de ce premier mode de réalisation, les premiers contacts électrique 5a, 5b forment des cathodes, notamment en contact avec une couche en GaN dopé n. Les premiers contacts électriques 5a, 5b sont préférentiellement une cathode du fait de la forte conductivité du GaN dopé n en regard de la conductivité du GaN dopé p. En effet, une électrode ponctuelle peut distribuer de manière homogène le courant dans le plan de la couche active de l'empilement à la condition que le semi-conducteur en contact avec ladite électrode ait une conductivité très supérieure à celle du semi-conducteur de conductivité opposée.

Selon un exemple particulier du premier mode de réalisation tel qu'illustré en figure 2, les premier et deuxième pixels 1a, 1b sont alignés le long d'une droite d1 de telle sorte que $L_p$ est une dimension de chacun desdits premier et deuxième pixels 1a, 1 b selon ladite droite d1, ladite dimension desdits premier et deuxième pixels étant incluse dans une surface principale d'émission du dispositif émissif incluant les surfaces d'émission des premier et deuxième pixels (de préférence cette surface principale d'émission est incluse dans un plan), $L_{C1}$ est la dimension du premier contact 5a, 5b de chacun des premier et deuxième pixels 1a, 1 b selon ladite droite d1 et $S_{C2}$ est la distance séparant les deux deuxièmes contacts 6a, 6b des deux premier et deuxième pixels 1a, 1 b selon ladite droite d1. Dans cet exemple particulier, la longueur de dispersion du premier pixel 1a est notamment inférieure à la distance de séparation D du premier contact 5a avec le deuxième pixel, qui peut se calculer par :

$$D = \frac{L_P}{2} - \frac{L_{C1}}{2} + \frac{S_{C2}}{2} \text{ (eq. 1)}$$

Par ailleurs, dans cet exemple particulier, la surface d'émission 4a, 4b de chaque pixel 1a, 1 b adopte préférentiellement la forme d'un carré dont deux côtés sensiblement parallèles sont aussi sensiblement parallèles à ladite droite d1. Ainsi, la distance $L_p$ correspond à la distance la plus courte séparant deux côtés opposés sensiblement parallèles de la surface d'émission du pixel concerné.

Plus particulièrement, la notion de « longueur de dispersion du premier pixel 1a inférieure à D » se base sur l'égalité J(x)/J(x=0)=1/e. En ce sens, en alimentant électriquement uniquement le pixel 1a le plus à gauche de la figure 2, on se retrouve avec :

J(x=D)<Jmin(Luminance >0)

Or on veut que J(x=D)=J(x=0).exp(-D/Ls) < Jmin(Luminance >0) avec Jmin(Luminance >0) = 1e-3 A/cm2 qui est une valeur observée sur des diodes du commerce ; à cette densité de courant, les diodes n'émettent pas encore de photons.

Si J(x=0)=100A/cm2, c'est-à-dire un courant de fonctionnement très élevé, on obtient J(x=D)=100.exp(-D/Ls) < 1 e-3 soit exp(-D/Ls) < 1e-3/1e-2=1 e-5 et plus particulièrement -D/Ls<-5ln10, ce qui vérifie le principe donné ci-dessus.

On obtient ainsi la condition D supérieur ou égal à environ 11 Ls.

Selon une autre condition acceptable, on peut choisir Jmin = 1 e-1 A/cm2, ce qui modifie les calculs précédents en -D/Ls<-3ln10, soit une condition D supérieur ou égal à environ 7Ls.

Plus généralement, on peut considérer d'autres modes de réalisation acceptables, en assouplissant les conditions précédentes, et en considérant D ≥ 5Ls, voire D > Ls.

On comprend donc qu'il est possible, lors de l'élaboration du dispositif émissif que l'on souhaite fabriquer de déterminer, une fois fixées les dimensions souhaitées des pixels, comment agencer le dispositif émissif. En ce sens, il faudra moduler la longueur de dispersion du courant Ls de manière à vérifier l'inégalité ci-avant. La longueur de dispersion du courant peut être modulée de plusieurs façons :

- diminution de l'épaisseur $d_n$ de la couche de n-GaN,
- augmentation de la résistivité $\rho_n$ de la couche de n-GaN,
- ou une combinaison des deux propositions précédentes, c'est-à-dire l'obtention d'une résistance par carré élevée de la couche de GaN-n.

Autrement dit, avec :

$$Ls = \sqrt{\left(\sum \rho_c + \sum \rho_\perp . d_\perp\right)\left|\frac{\rho_n}{d_n} - \frac{\rho_e}{d_e}\right|^{-1}}$$

$$Si \quad \frac{\rho_n}{d_n} \gg \frac{\rho_e}{d_e} \quad alors \quad \left|\frac{\rho_n}{d_n} - \frac{\rho_e}{d_e}\right| = \left|\frac{\rho_n}{d_n}\right|$$

$$Ls = \sqrt{\left(\rho_n d_n + \rho_p d_p\right)\left|\frac{\rho_n}{d_n}\right|^{-1}} = \sqrt{\frac{\left(\rho_n d_n + \rho_p d_p\right)}{\frac{\rho_n}{d_n}}} = \sqrt{\frac{\rho_n d_n}{\frac{\rho_n}{d_n}} + \frac{\rho_p d_p}{\frac{\rho_n}{d_n}}} = \sqrt{d_n^2 + \frac{\rho_p d_p d_n}{\rho_n}}$$

De l'expression de Ls, on déduit que pour réduire Ls, il faut que $d_n$ soit petit (1er critère), et que $\frac{\rho_p d_p d_n}{\rho_n}$ soit petit. Pour minimiser $\frac{\rho_p d_p d_n}{\rho_n}$, il faut minimiser $\frac{\rho_p}{\rho_n}$ c'est-à-dire minimiser $\rho_p$ et/ou maximiser $\rho_n$.

Dans la pratique, il est aisé de maximiser $\rho_n$ car la résistivité des couches de n-GaN peut être aisément modulée entre 1e-3 Ohm.cm et 100 Ohm.cm. En revanche, la résistivité des couches de p-GaN est difficile à minimiser puisque les valeurs courantes sont de l'ordre de 1 Ohm.cm. Pour un fonctionnement optimal d'un pixel concerné formant une diode, la contrainte $\frac{\rho_p}{\rho_n}$ sera de préférence choisie telle que

$$100 > \frac{\rho_p}{\rho_n} > 1$$

(soit de préférence 1> $\rho_n$ > 1e-2 et en particulier 1> $\rho_n$ > 1e-1 si $\rho_p$ = 1 Ohm.cm) (2ième critère).

Dans la pratique également et toujours dans un objectif de fonctionnement optimal du pixel concerné, l'épaisseur de GaN-p étant de l'ordre de quelques centaines de nanomètres, pour minimiser le terme $\dfrac{\rho_p d_p d_n}{\rho_n}$ on préfèrera réduire l'épaisseur de GaN-n et ne pas réduire l'épaisseur de GaN-p (soit de préférence $d_n < 1\mu m\ avec\ d_p \approx 300 nm$ et en particulier $d_n < 700 nm\ avec\ d_p \approx 300 nm$).

En diminuant drastiquement la surface du pixel, il apparait une seconde limitation induite par les dimensions de la cathode. En effet, la cathode requiert des dimensions minimales pour assurer le passage d'un courant d'intensité élevée (100A/cm2) et donc couvrira une part de la surface pixel d'autant plus importante que la surface du pixel est faible. Dans l'exemple de la figure 2, la surface d'émission est occultée en partie par une cathode non transparente.

Autrement dit, on comprend de ce qui a été écrit ci-dessus que l'étape de configuration peut comporter : une étape dans laquelle la surface d'émission 4a, 4b des premier et deuxième pixels 1 a, 1 b est choisie ; une étape dans laquelle des formes et dimensions des contacts électriques des premier et deuxième pixels 1a, 1 b sont choisies; une étape d'élaboration de l'empilement émissif 2 en fonction des surfaces d'émission 4a, 4b choisies et des formes et dimensions des contacts électriques choisis. L'étape d'élaboration peut notamment comporter l'utilisation d'une longueur de dispersion du courant choisie comme décrit ci-avant.

Plus particulièrement, l'étape d'élaboration de l'empilement émissif 2 comporte une étape de détermination d'un empilement émissif de test et une étape de calcul de la longueur de dispersion associée à l'empilement émissif de test déterminé, ledit empilement émissif 2 de test étant validé si il satisfait un critère de comparaison de la longueur de dispersion calculée avec une dimension associée au moins au premier pixel 1a, autrement dit si l'empilement émissif de test permet l'allumage d'un pixel sans allumer le pixel adjacent alors en état éteint.

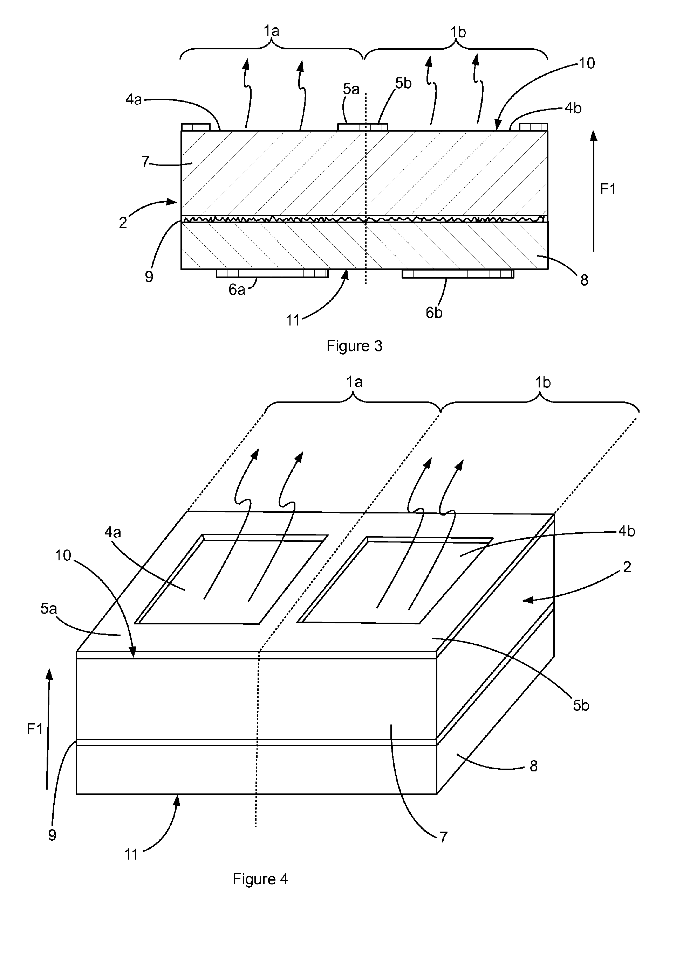

Selon un deuxième mode de réalisation illustré aux figures 3 et 4, les premier et deuxième pixels 1 a, 1 b comportent chacun un premier contact électrique 5a, 5b configuré de sorte à injecter des porteurs de charge d'un premier type dans l'empilement émissif 2 et un deuxième contact électrique 6a, 6b configuré de sorte à injecter des porteurs de charge d'un deuxième type dans l'empilement émissif 2. Selon ce mode de réalisation, les premier et deuxième contacts électriques de chacun des premier et deuxième pixels 1a, 1 b sont disposés de part et d'autre de l'empilement émissif 2 sans être en vis-à-vis.

Autrement dit, les premiers contacts électriques 5a, 5b et deuxièmes contacts électriques 6a, 6b des premier et deuxième pixels 1a, 1 b sont avantageusement agencés de telle sorte que leurs projections sur un même plan, ledit même plan étant perpendiculaire à la direction F1 d'empilement dudit l'empilement émissif 2, ne se recouvrent pas. Ceci permet notamment de ne pas créer une zone d'ombre située entre les premier et deuxième contacts d'un pixel où les photons seraient plus difficiles à restituer.

Dans ce cas, préférentiellement, les premiers contacts électriques 5a, 5b adoptent une forme délimitant la périphérie des surfaces d'émission 4a, 4b des premier et deuxième pixels 1a, 1 b. Autrement dit, les premier et deuxième contacts électriques 5a, 5b peuvent adopter chacun la forme d'une boucle fermée s'étendant à la périphérie dudit pixel correspondant.

Par ailleurs, dans cette réalisation, les premiers contacts électriques 5a, 5b des premier et deuxième pixels 1a, 1 b sont préférentiellement reliés électriquement entre eux. Ces premier et deuxième contacts électriques 5a, 5b peuvent être formés par des zones d'une même couche électriquement conductrice. Ici, le premier contact 5b le deuxième pixel 1 b peut avoir une partie commune avec le premier contact 5a du premier pixel 1a.

Autrement dit, selon ce deuxième mode de réalisation, le dispositif émissif peut comporter une configuration dans laquelle :

- les premiers contacts électriques 5a, 5b des premier et deuxième pixels 1a, 1b injectent des porteurs de charge du premier type dans l'empilement émissif 2,

- le deuxième contact électrique 6a du premier pixel 1a injecte des porteurs de charge du deuxième type dans l'empilement émissif 2,

- le centre du premier pixel 1a perçoit la somme des contributions de chaque point du premier contact électrique 5a du premier pixel 1a de sorte qu'une partie de l'empilement émissif 2 correspondant au premier pixel 1 a génère des photons,

- le deuxième contact électrique 6b du deuxième pixel 1 b n'étant pas polarisé, les porteurs injectés par le deuxième contact électrique 6a du premier pixel 1 a ne permettent pas de générer des photons au sein d'une autre partie de l'empilement émissif 2 associée au deuxième pixel 1 b.

On comprend alors que dans ce deuxième mode de réalisation, en positionnant le premier contact électrique (de préférence la cathode) en périphérie, la surface émissive du pixel délimitée par les dimensions planaires du deuxième contact électrique (de préférence l'anode) n'est pas du tout occultée par le premier contact électrique. Intuitivement on pourrait imaginer que le centre du pixel n'est pas alimenté du fait d'une longueur de dispersion du courant faible. Cependant, chaque point de l'électrode périphérique se comporte comme une source de courant et le centre du pixel perçoit alors la somme des contributions de chaque point dudit premier contact électrique (comme le prévoit le théorème de superposition). Il y a donc une concentration du courant. En revanche en périphérie du premier contact électrique, la contribution de chaque point de l'électrode est dispersée sur une surface plus importante. Il y a alors une dilution du courant.

De manière applicable à tout ce qui a été dit ci avant, les premier et/ou deuxième contacts électriques 5a, 5b seront choisis ou formés de telle manière que l'interface entre le premier contact électrique 5a et/ou le deuxième contact électrique 5b avec l'empilement émissif soit faiblement réfléchissant. La notion de faiblement réfléchissant signifie avantageusement de telle sorte que la réflexion entre l'électrode (premier et/ou deuxième contact électrique 5a, 5b) et le semi-conducteur (l'empilement émissif 2) réfléchisse moins de 60%, et de préférence moins de 50% de la lumière générée par l'empilement émissif 2. Ceci peut notamment être réalisé lorsque les premier et/ou deuxième contacts électriques 5a, 5b sont en contact intime avec l'empilement émissif 2 et sont formés par une couche qui ne contient pas de Sm, Ag ou Al et dont l'épaisseur n'est pas supérieure à l'épaisseur de peau du métal. Par exemple il pourra être utilisé les matériaux suivants dont l'épaisseur est indiquée entre parenthèse : Au (500nm) ou Ti(20nm)/Au(500nm) ou Cr(20nm)/Au(500nm), etc.

On conserve donc un « pseudo-isolement » des pixels les uns par rapport aux autres. Les électrodes situées au niveau des surfaces d'émission des pixels peuvent avoir une portion opaque aux photons émis de sorte à bien délimiter les pixels voisins.

Cet agencement des premiers contacts en forme de boucles fermées et tous en contact électriques les uns avec les autres permet de distribuer de manière homogène le courant au sein des pixels. En outre, les pixels sont mieux définis, et il en résulte un meilleur contraste, conférant un excellent confort visuel. Ainsi, préférentiellement, dans le deuxième mode de réalisation, les premiers contacts électriques sont formés de telle sorte à être opaque aux photons générés par les pixels.

Ci-dessous sont donnés quatre exemples particuliers de réalisation.

Selon un premier exemple, l'épaisseur $d_n$ de la première couche semi-conductrice 7, notamment dopée n, est de 700nm, l'épaisseur $d_p$ de la deuxième couche semi-conductrice 8, notamment dopée p, est de 300nm, et $\rho_n$=1e-3Ohm.cm, $\rho_p$=1 Ohm.cm. On obtient donc une longueur de dispersion du courant Ls = 14,5µm. En ce sens, la demi-longueur de pixel correspondant est avantageusement choisie supérieure à 159.5µm par exemple 160µm.

Selon un deuxième exemple, l'épaisseur $d_n$ de la première couche semi-conductrice 7, notamment dopée n, est de 1µm, l'épaisseur $d_p$ de la deuxième couche semi-conductrice 8, notamment dopée p, est de 300nm, et $\rho_n$=1e-1Ohm.cm, $\rho_p$=1 Ohm.cm. On obtient donc une longueur de dispersion du courant Ls = 2µm. En ce sens, la demi-longueur de pixel correspondant est avantageusement choisie supérieure à 22µm par exemple 25µm. Dans cette exemple, on préféra le mode de réalisation dans lequel les électrodes ne sont pas face à face car sinon l'électrode supérieure devrait avoir des dimensions inférieure à 25µm ce qui serait coûteux technologiquement parlant et ce qui masquerait un part conséquente de la surface émissive de la diode.

Selon un troisième exemple, l'épaisseur $d_n$ de la première couche semi-conductrice 7, notamment dopée n, est de 2µm, l'épaisseur $d_p$ de la deuxième couche semi-conductrice 8, notamment dopée p, est de 300nm, et $\rho_n$=1e-2 Ohm.cm, $\rho_p$=1 Ohm.cm. On obtient donc une longueur de dispersion du courant Ls = 8µm. En ce sens, la demi-longueur de pixel correspondant est avantageusement choisie supérieure à 88µm par exemple 90µm.

Selon un quatrième exemple, l'épaisseur $d_n$ de la première couche semi-conductrice 7, notamment dopée n, est de 1µm, l'épaisseur $d_p$ de la deuxième couche semi-conductrice 8, notamment dopée p, est de 300nm, et $\rho_n$=1e-2 Ohm.cm, $\rho_p$=1 Ohm.cm. On obtient donc une longueur de dispersion du courant Ls = 5,5µm. En ce sens, la demi-longueur de pixel correspondant est avantageusement choisie supérieure à 60.5µm par exemple 65µm.

Dans les exemples donnés ci-dessus, la demi-longueur d'un pixel correspond à la distance minimale séparant le premier contact d'un pixel d'un pixel adjacent dans le cadre du premier mode de réalisation. Dans ce cas, en prenant les premières électrodes 5 (premier contacts électriques des pixels) reliées électriquement de sorte à être communes à tous les pixels, il ne faut pas qu'un point d'une première électrode associée à un pixel puisse générer un courant qui permette d'allumer un pixel adjacent, cette question se posant notamment lorsque deux pixels adjacents sont allumés mais à des intensités différentes. Les valeurs numériques ont été obtenues dans ces exemples en considérant la condition la plus exigeante de D ≥ 11 Ls. Naturellement, d'autres modes de réalisation peuvent être aisément obtenus en considérant une autre condition, notamment D ≥ 5Ls.

Dans la présente description, il a été fait référence à deux pixels adjacents du dispositif émissif. Bien entendu, le dispositif émissif peut comporter une pluralité de pixels agencés, par exemple, sous la forme d'une matrice. Dans ce cas pour chaque couple de pixels adjacents de la pluralité de pixels, ce qui a été dit dans la présente description peut s'appliquer.

**Revendications**

1. Dispositif émissif comportant des premier et deuxième pixels (1a, 1b) adjacents partageant un empilement émissif (2) commun de semi-conducteurs et définissant chacun une surface d'émission (4a, 4b) de photons, **caractérisé en ce que** :

   - les premier et deuxième pixels (1a, 1b) comportent chacun un premier contact électrique (5a, 5b) configuré de sorte à injecter des porteurs de charge d'un premier type dans l'empilement émissif (2), et un deuxième contact électrique (6a, 6b) configuré de sorte à injecter des porteurs de charge d'un deuxième type dans l'empilement émissif (2),
   - les premiers contacts électriques (5a, 5b) des premier et deuxième pixels (1 a, 1 b) sont reliés électriquement entre eux,
   - les deuxièmes contacts électriques (6a, 6b) des premier et deuxième pixels (1a, 1b) sont configurés de sorte à être polarisés de manière sélective par un système d'adressage du dispositif émissif en vue de l'injection des porteurs de charge du deuxième type,

   et **en ce que** lorsque le premier pixel (1a) est alimenté en courant, la densité de courant entre le premier contact électrique (5b) du deuxième pixel (1b) et le deuxième contact électrique (6a) du premier pixel (1a) est inférieure à la densité de courant pour lequel ledit deuxième pixel (1b) commence à émettre des photons de sorte que les premier et deuxième pixels (1a, 1b) sont configurés pour qu'une alimentation en courant du premier pixel (1 a) provoque l'émission de photons, par l'empilement émissif (2), uniquement au niveau de la surface d'émission (4a) dudit premier pixel (1a).

2. Dispositif selon la revendication précédente, **caractérisé en ce que** la surface de contact du premier contact électrique (5a, 5b) de chaque pixel (1a, 1 b) avec l'empilement émissif (2) est inférieure à la surface de contact du deuxième contact électrique (6a, 6b) de chaque pixel (1a, 1 b) avec l'empilement émissif (2).

3. Dispositif selon la revendication précédente, **caractérisé en ce que** le premier pixel (1a) comporte une longueur de dispersion du courant, et **en ce que** la distance de séparation du premier contact électrique (5a) du premier pixel (1a) avec le deuxième pixel (1b) est supérieure à la longueur de dispersion du courant du premier pixel (1a) ou supérieure ou égale à au moins cinq fois la longueur de dispersion du courant du premier pixel (1a).

4. Dispositif selon l'une quelconque des revendications précédentes, **caractérisé en ce que** les premier et deuxième pixels (1a, 1 b) sont alignés le long d'une droite de telle sorte que $L_p$ est une dimension de chacun desdits premier et deuxième pixels (1a, 1 b) selon ladite droite, ladite dimension desdits premier et deuxième pixels (1 a, 1 b) étant incluse dans une surface principale d'émission du dispositif émissif incluant les surfaces d'émission (4a, 4b) desdits premier et deuxième pixels (1a, 1 b), $L_{C1}$ est une dimension du premier contact (5a, 5b) de chacun des premier et deuxième pixels (1a, 1b) selon ladite droite et $S_{C2}$ est une distance séparant les deux deuxièmes contacts (6a, 6b) des premier et deuxième pixels (1a, 1 b) selon ladite droite, et **en ce que** la distance D avec $D = \frac{L_P}{2} - \frac{L_{C1}}{2} + \frac{S_{C2}}{2}$ vérifie la condition D > Ls, ou D ≥ 5Ls, ou D ≥ 7Ls, ou D ≥ 11 Ls, où Ls est la longueur de dispersion du courant du premier pixel.

5. Dispositif selon la revendication 1, **caractérisé en ce que** les premier et deuxième pixels (1a, 1b) comportent chacun un premier contact électrique (5a, 5b) configuré de sorte à injecter des porteurs de charge d'un premier type dans l'empilement émissif (2) et un deuxième contact électrique (6a, 6b) configuré de sorte à injecter des porteurs de charge d'un deuxième type dans l'empilement émissif (2), et **en ce que** les premier et deuxième contacts électriques de chacun des premiers et deuxième pixels (1 a, 1 b) sont disposés de part et d'autre de l'empilement émissif (2) sans être en vis-à-vis.

6. Dispositif selon la revendication précédente, **caractérisé en ce que** les premiers contacts électriques (5a, 5b) des premier et deuxième pixels (1a, 1b) adoptent une forme délimitant la périphérie des surfaces d'émission (4a, 4b) des premier et deuxième pixels (1 a, 1 b), les premiers contacts électriques (5a, 5b) et deuxièmes contacts électriques (6a, 6b) des premier et deuxième pixels (1 a, 1 b) étant agencés de telle sorte que leurs projections sur un même plan, ledit même plan étant perpendiculaire à la direction d'empilement dudit l'empilement émissif (2), ne se recouvrent pas.

**7.** Dispositif selon la revendication précédente, **caractérisé en ce que** les premiers contacts électriques (5a, 5b) des premier et deuxième pixels (1 a, 1 b) sont reliés électriquement entre eux.

**8.** Dispositif selon l'une des revendications 6 ou 7, **caractérisé en ce qu'**il comporte une configuration dans laquelle :

- les premiers contacts électriques (5a, 5b) des premier et deuxième pixels (1a, 1b) injectent des porteurs de charge du premier type dans l'empilement émissif (2),
- le deuxième contact électrique (6a) du premier pixel (1a) injecte des porteurs de charge du deuxième type dans l'empilement émissif (2),
- le centre du premier pixel (1a) perçoit la somme des contributions de chaque point du premier contact électrique (5a) du premier pixel (1a) de sorte qu'une partie de l'empilement émissif (2) correspondant au premier pixel (1 a) génère des photons,
- le deuxième contact électrique (6b) du deuxième pixel (1 b) n'étant pas polarisé, les porteurs injectés par le deuxième contact électrique (6a) du premier pixel (1a) ne permettent pas de générer des photons au sein d'une autre partie de l'empilement émissif (2) associée au deuxième pixel (1 b).

**9.** Dispositif selon l'une des revendications précédentes, **caractérisé en ce que** l'empilement émissif (2) comporte une première face (10), sur laquelle repose les premiers contacts électriques (5a, 5b) desdits premier et deuxième pixels (1a, 1b), et une deuxième face (11), opposée à la première face (10), sur laquelle repose les deuxièmes contacts électriques (6a,6b) desdits premier et deuxième pixels (1a, 1b), ladite première face (10) de l'empilement émissif (2) formant une face principale d'émission du dispositif émissif.

**10.** Dispositif selon l'une quelconque des revendications précédentes, **caractérisé en ce que** les premier et deuxième pixels (1a, 1 b) sont identiques.

**11.** Procédé d'élaboration d'un dispositif émissif comprenant des premier et deuxième pixels (1a, 1 b) adjacents partageant un empilement émissif (2) commun de semi-conducteurs et définissant chacun une surface d'émission (4a, 4b) de photons, ledit procédé comportant une étape de configuration de l'empilement émissif (2) de telle sorte que l'alimentation en courant du premier pixel (1a) provoque l'émission de photons, par l'empilement émissif (2), uniquement au niveau de la surface d'émission (4a) dudit premier pixel (1a).

**12.** Procédé selon la revendication précédente, **caractérisé en ce que** l'étape de configuration comporte :

- une étape dans laquelle la surface d'émission (4a, 4b) des premier et deuxième pixels (1 a, 1 b) est choisie,
- une étape dans laquelle des formes et dimensions des contacts électriques des premier et deuxième pixels (1 a, 1 b) sont choisies,
- une étape d'élaboration de l'empilement émissif (2) en fonction des surfaces d'émission (4a, 4b) choisies et des formes et dimensions des contacts électriques choisis.

**13.** Procédé selon la revendication précédente, **caractérisé en ce que** l'étape d'élaboration de l'empilement émissif (2) comporte une étape de détermination d'un empilement émissif (2) de test et une étape de calcul de la longueur de dispersion associée à l'empilement de test déterminé, ledit empilement émissif (2) de test étant validé si il satisfait un critère de comparaison de la longueur de dispersion calculée avec une dimension associée au moins au premier pixel (1a).

Figure 1 (Art antérieur)

Figure 2

Figure 3

Figure 4

**Europäisches Patentamt**

**European Patent Office**

**Office européen des brevets**

# RAPPORT DE RECHERCHE EUROPEENNE

Numéro de la demande

EP 15 19 4793

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 2007 207977 A (CANON KK) 16 août 2007 (2007-08-16) * alinéas [0011] - [0013], [0018] - [0025], [0033] - [0044]; figures 1-6 * ----- | 1-10 | INV. H01L27/15 H01L33/08 |
| X | US 2012/061711 A1 (LI FANG-I [TW] ET AL) 15 mars 2012 (2012-03-15) * alinéas [0016] - [0018]; figures 2,3 * ----- | 1,2,5,10 | |
| X | US 2010/078659 A1 (IIZUKA KAZUYUKI [JP] ET AL) 1 avril 2010 (2010-04-01) * alinéas [0069] - [0089]; figures 2a-2n * ----- | 11-13 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| La Haye | 28 janvier 2016 | Chin, Patrick |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 15 19 4793

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-01-2016

| Document brevet cité au rapport de recherche | Date de publication | Membre(s) de la famille de brevet(s) | Date de publication |
|---|---|---|---|
| JP 2007207977 A | 16-08-2007 | AUCUN | |
| US 2012061711 A1 | 15-03-2012 | CN 102403431 A | 04-04-2012 |
| | | JP 2012064917 A | 29-03-2012 |
| | | KR 20120028196 A | 22-03-2012 |
| | | TW 201212288 A | 16-03-2012 |
| | | US 2012061711 A1 | 15-03-2012 |
| US 2010078659 A1 | 01-04-2010 | CN 101714595 A | 26-05-2010 |
| | | JP 2010080817 A | 08-04-2010 |
| | | US 2010078659 A1 | 01-04-2010 |

EPO FORM P0460

Pour tout renseignement concernant cette annexe : voir Journal Officiel de l'Office européen des brevets, No.12/82